**Europäisches Patentamt**

(19) **European Patent Office**

**Office européen des brevets**

(11) Veröffentlichungsnummer: **0 031 471**
**B1**

(12) # EUROPÄISCHE PATENTSCHRIFT

(45) Veröffentlichungstag der Patentschrift:
06.03.85

(51) Int. Cl.⁴: **G 01 R 19/165**, G 08 B 29/00, **B 61 L 7/10**

(21) Anmeldenummer: 80107435.2

(22) Anmeldetag: 27.11.80

(54) Einrichtung zum Überwachen des Betriebszustandes eines elektrischen Verbrauchers.

(30) Priorität: 27.12.79 DE 2952462

(43) Veröffentlichungstag der Anmeldung:
08.07.81 Patentblatt 81/27

(45) Bekanntmachung des Hinweises auf die Patenterteilung:
06.03.85 Patentblatt 85/10

(84) Benannte Vertragsstaaten:
AT BE CH DE FR GB IT LI NL SE

(56) Entgegenhaltungen:
DE - A - 1 690 158
DE - B - 1 130 922
US - A - 3 341 748
US - A - 3 885 231
US - A - 3 992 636

(73) Patentinhaber: Siemens Aktiengesellschaft, Berlin und München Wittelsbacherplatz 2, D-8000 München 2 (DE)

(72) Erfinder: Boschulte, Rainer, Ing. grad., Dahlumer Strasse 8, D-3300 Braunschweig (DE)
Erfinder: Köhnecke, Heinrich, Dipl.-Ing., Dorfwinkel 7, D-3300 Braunschweig (DE)
Erfinder: Mücke, Siegfried, Ing. grad., Hans-Geitel-Strasse 17, D-3300 Braunschweig (DE)

**Beschreibung**

Die Erfindung bezieht sich auf eine Einrichtung nach dem Oberbegriff des Patentanspruchs 1.

Zum Überwachen des Betriebszustandes elektrischer Verbraucher, z. B. der Signallampen eines Lichtsignals, ist es nicht nur bekannt, den jeweiligen Betriebszustand der elektrischen Verbraucher durch in den Strompfad der Verbraucher geschaltete Überwacher zu erfassen und an eine beispielsweise zentrale Steuerstelle zu melden, sondern es ist auch bekannt, das ordnungsgerechte Funktionsverhalten der Überwacher zu überprüfen. Hierzu werden bei einer bekannten Fernwirkanlage (DE-B-1 690 158) die Überwacher unabhängig vom Schaltzustand der von ihnen überwachten elektrischen Verbraucher vorübergehend in den einen und dann in den anderen Schaltzustand gesteuert. Der Empfang der dabei an die Steuerstelle übertragenen Zustandsmeldungen für die Überwacher wird in der Steuerstelle umgesetzt in ein das ordnungsgerechte Funktionsverhalten der Überwacher kennzeichnendes Signal; beim Ausbleiben der erwarteten Zustandsmeldungen wird eine Störungsmeldung zum Einleiten vorgegebener Schaltroutinen ausgelöst.

Mitunter reicht es nicht aus, zu wissen, ob ein elektrischer Verbraucher stromdurchflossen ist oder nicht; zur Sicherstellung eines bestimmten Betriebsverhaltens des elektrischen Verbrauchers ist eine eindeutige Aussage darüber notwendig, ob der über den Verbraucher fließende Strom innerhalb vorgegebener Grenzen liegt. Bei angeschaltetem Verbraucher darf der Verbraucherstrom nicht unterhalb eines vorgegebenen Schwellwertes liegen, weil dann der Verbraucher nicht ordnungsgerecht arbeiten kann; der Verbraucherstrom darf aber einen oberen Wert auch nicht überschreiten, weil dann der Verbraucher Schaden nehmen kann. Außerdem könnte das Fließen eines oberhalb eines vorgegebenen Schwellwertes liegenden Stromes ein Anzeichen dafür sein, daß der gemessene Verbraucherstrom tatsächlich nicht über den Verbraucher fließt, sondern über einen niederohmigen Nebenschluß zum Verbraucher.

Aus der DE-B-1 130 922 ist bereits eine Vorrichtung zur Überwachung des oberen und des unteren Grenzwertes eines Gleichspannungspegels bekannt, mit der es möglich ist festzustellen, ob eine zu überwachende Gleichspannung innerhalb eines vorgegebenen Spannungsbereiches liegt oder von einer Nennspannung unzulässig weit abweicht. Die Vorrichtung besteht aus zwei Schwellwertschaltern, deren Steuereingängen die zu überwachende Gleichspannung zugeführt wird; die Ansprechpegel der beiden Schwellwertschalter sind durch den vorgegebenen Mindest- und den vorgegebenen Höchstwert der zu überwachenden Gleichspannung bestimmt. Die Schwellwertschalter steuern einen nachgeschalteten Überwacher in der Weise, daß der Überwacher bei einer Gleichspannung innerhalb des vorgegebenen Spannungsbereiches den einen Schaltzustand und bei einer Gleichspannung außerhalb des vorgegebenen Spannungsbereiches den anderen Schaltzustand einnimmt. Für das sprunghafte Schalten der Schwellwertschalter beim Erreichen vorgegebener Schwellwerte der zu überwachenden Gleichspannung wird die kumulative Wirkung zweier Schalttransistoren aufeinander ausgenutzt, d. h. das Durchsteuern eines Schalttransistors trägt gleichzeitig zum Sperren des anderen bei und umgekehrt.

Aus der US-A-3 341 748 ist ferner eine aus zwei Schwellwertschaltern bestehende Schwellwertschalteranordnung gemäß dem Oberbegriff des Patentanspruchs 1 bekannt, bei der ein auf das Überschreiten eines vorgegebenen oberen Schwellwertes reagierender Schwellwertschalter bei seinem Ansprechen einen auf das Überschreiten eines vorgegebenen unteren Schwellwertes reagierenden Schwellwertschalter in die Schaltstellung steuert, die dieser auch bei einem Steuerpotential unterhalb des vorgegebenen unteren Schwellwertes einnimmt. Zum Ausgeben des jeweiligen Überwachungsergebnisses dient ein gesondertes Überwacherrelais.

Mit diesen bekannten Schwellwertschalteranordnungen ist es nicht möglich, den Betriebszustand eines elektrischen Verbrauchers zu überwachen, weil die ihnen jeweils zugeführten Steuerpotentiale unabhängig sind vom Betriebszustand irgendwelcher Verbraucher. Zwar ließen sich die bekannten Schwellwertschalteranordnungen durch Anwendung der aus der DE-B-1 690 158 bekannten Maßnahmen während des Betriebes auf Funktionsfähigkeit überprüfen, indem sie durch Zuführen gesonderter Prüfkommandos in ihre beiden möglichen Betriebszustände umgesteuert werden. Durch diesen Prüfvorgang ließe sich aber nur die Funktionsfähigkeit des eigentlichen Überwachers testen; das Überwachungsergebnis würde nichts darüber aussagen, ob die Schaltmittel, über die der Überwacher betriebsmäßig gesteuert wird, ihrerseits ebenfalls funktionsfähig sind, d. h. ob der Überwacher durch sie auch tatsächlich in der gewünschten Weise gesteuert wird und auf diese Steuergrößen in der erwünschten Weise reagiert.

Aus der US-A-3 992 636 ist es schließlich bekannt, den Schaltzustand eines Sensors zu überwachen. Solange der Sensor hochohmig ist und solange die Zuleitungen zu ihm weder aufgetrennt noch kurzgeschlossen sind, registriert eine Überwachungseinrichtung über eine dem Sensor parallelgeschaltete Diode periodische Steuersignale. Beim Auftrennen und beim Kurzschließen der Zuleitungen bleiben diese Steuersignale aus, und die Störung ist erkennbar. Eine Funktionsprüfung des Sensors selbst ist nicht vorgesehen.

Aufgabe der vorliegenden Erfindung ist es, die im Oberbegriff des Patentanspruches 1 näher bezeichnete Schwellwertschalteranordnung für die Überwachung des Betriebszustandes eines elektrischen Verbrauchers nutzbar zu machen und so auszubilden, daß sich die Funktionsfähigkeit aller in den Steuer- und den Überwachungsvorgang einbezogenen Schaltmittel überprüfen läßt. Dabei soll die Funktionsfähigkeit der Überwachungseinrichtung unabhängig vom Betriebszustand des zu überwachenden Verbrauchers feststellbar sein, also sowohl dann, wenn der Verbraucher angeschaltet ist als auch dann, wenn er abgeschaltet ist. In die Prüfung auf Funktionsfähigkeit soll neben allen am eigentlichen Steuer- und Überwachungsvorgang beteiligten Schaltmitteln auch der zu überwachende Verbraucher selbst einbezogen sein. Die Überwachungseinrichtung soll nicht nur eine hohe Betriebssicherheit aufweisen, d. h. jede Störung und jeder Bauteildefekt soll durch eine Störungsmeldung erkennbar sein; durch Verwendung von nur wenigen, handelsüblichen Bauelementen soll auch eine hohe Zuverlässigkeit der erfindungsgemäßen Überwachungseinrichtung erreichbar sein.

Die Erfindung löst diese Aufgabe durch die Anwendung der im Kennzeichen des Patentanspruchs 1 angegebenen Merkmale.

Vorteilhafte Ausgestaltungen der Erfindung sind in den Patentansprüchen 2 und 3 angegeben.

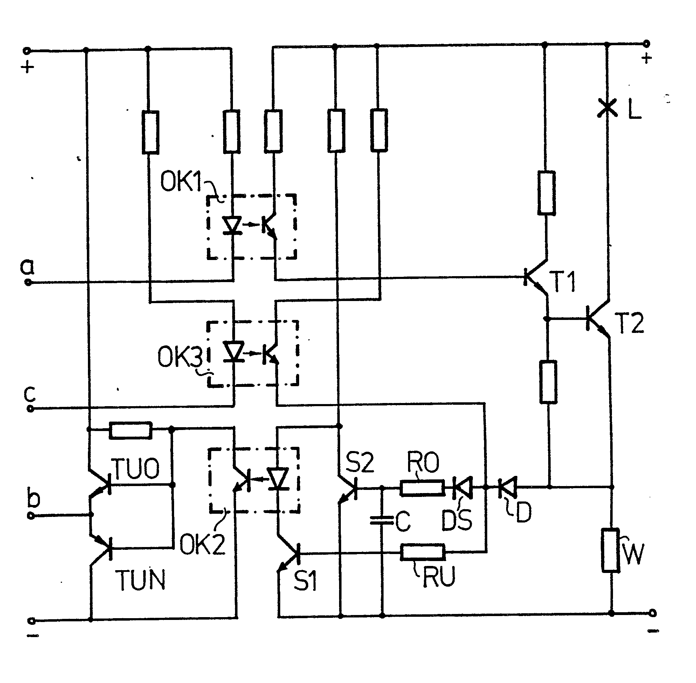

Ein Ausführungsbeispiel der Erfindung ist in der Zeichnung dargestellt und wird im nachfolgenden näher erläutert. Die Zeichnung zeigt die in der Nähe eines Lichtsignals mit der Signallampe L angeordneten Schaltmittel zum Ansteuern und Überwachen der Signallampe sowie die Schaltmittel zum Durchführen der Funktionsprüfung von Lampe und Lampenüberwacher. Die aus einer vorzugsweise örtlichen Spannungsquelle versorgte Signallampe L ist von den zur Steuerstelle führenden Steuer- und Überwachungsleitungen durch zwischengeschaltete Optokoppler OK1 bis OK3 galvanisch getrennt; das hat den Vorteil, daß die am linken Teil der Schaltung abgreifbaren bzw. zuführbaren Signale unabhängig von der für den Betrieb der Signallampe L erforderlichen Spannung, von z. B. 12 V, auf einem Potential liegen können, das für die Verarbeitung dieser Signale in elektronischen Schaltkreisen direkt geeignet ist, z. B. 5 V. Über den Optokoppler OK1 erfolgt die Anschaltung der Signallampe. Der Optokoppler OK1 wird ausgangsseitig niederohmig, sobald seine Eingangsklemme a auf Massepotential gelegt ist; er schaltet dabei den Transistor T1 durch. Dieser Transistor dient als Vorverstärker für einen nachgeschalteten Leistungstransistor T2 im Stromkreis der anzuschaltenden Signallampe L. Diese Signallampe zieht, sobald sie angeschaltet ist — einen bestimmten Verbraucherstrom, der an einem in den Stromkreis geschalteten Meßwiderstand W einen entsprechenden Spannungsabfall verursacht. Dieser Spannungsabfall stellt das Steuerpotential für zwei Schalter S1, OK2 und S2, OK2 dar, die zum Steuern eines Lampenüberwachers dienen. Liegt der über den Meßwiderstand W fließende Strom oberhalb eines für die Signallampe L vorgegebenen unteren Schwellwertes, dann wird die Schaltstrecke S1 durch das ihr über eine Entkopplungsdiode D und einen Widerstand RU zugeführte Steuerpotential durchlässig geschaltet; sie schaltet dabei die Leuchtdiode eines Optokopplers OK2 an. Dieser Optokoppler wird ausgangsseitig niederohmig und steuert dabei einen Transistor TUN durch, der das negative Potential auf die Anschlußklemme b schaltet. Negatives Potential an dieser Anschlußklemme bedeutet, daß der Lampenüberwacher für die Signallampe einen Speisestrom registriert, der zwischen dem unteren und dem oberen zulässigen Schwellwert liegt.

Wenn der über den Meßwiderstand W fließende Verbraucherstrom in unzulässiger Weise einen vorgegebenen oberen Schwellwert überschreitet, steuert das am Meßwiderstand W abgreifbare Potential über die Entkopplungsdiode D, den Widerstand R0 und eine Diode DS den zweiten Schalter S2, OK2 durch. Dieser Schalter schaltet die bislang über die Schaltstrecke S1 angeschaltete Diode des Optokopplers OK2 kurz. Dadurch wird der Fototransistor dieses Optokopplers hochohmig, was dazu führt, daß der bislang durchgeschaltete Transistor TUN wegen des jetzt an seinem Steuereingang liegenden positiven Potentials sperrt und der Transistor TU0 durchschaltet. Damit ist an der Anschlußklemme b nunmehr positives Potential abgreifbar, das in einer nicht dargestellten Auswertelogik umgesetzt wird in ein Signal mit der Bedeutung »Unzulässige Abweichung des Verbraucherstromes von seinem Nennwert«. In den Steuerstromkreis des zweiten Schalters S2, OK2 ist eine Diode DS geschaltet; diese Diode stellt sicher, daß die Schaltstrecke S2 tatsächlich erst dann durchschaltet, wenn die ihr zugeführte Spannung um den Betrag der Durchlaßspannung der Diode höher ist als die zum Durchsteuern der ersten Schaltstrecke S1 erforderliche Spannung.

Wenn der Verbraucher L abgeschaltet ist oder über ihn ein unterhalb des vorgegebenen unteren Schwellwertes liegender Speisestrom fließt, dann ist weder die Schaltstrecke S1 noch die Schaltstrecke S2 durchgesteuert. Auch in diesem Falle wird die Ausgangsklemme b über den Transistor TU0 mit positivem Potential beaufschlagt. Dieses Potential kennzeichnet, abhängig davon, ob an die Anschlußklemme a Steuerpotential gelegt wurde oder nicht, entweder den nicht ordnungsgerechten Betriebszustand »Unzulässige Abweichung des Verbraucherstromes von seinem Nennwert« oder den ordnungsgerechten Zustand »Verbraucher abgeschaltet«.

Für die Funktionsprüfung des Überwachers ist vorgesehen, diesen vorübergehend in die Schaltzustände zu führen, in die er bei unterschiedlich hohem Verbraucherstrom gelangen kann. Ist zu dem Zeitpunkt, an dem die Funktionsprüfung durchgeführt werden soll, der Verbraucher angeschaltet, so ist bei ordnungsgerechtem Betriebszustand der Schalter S1, OK2 durchgesteuert, und an der Anschlußklemme b ist negatives Potential abgreifbar. Für die Funktionsprüfung des Überwachers ist es dann erforderlich, den Überwacher nacheinander mit Steuerspannungen zu versorgen, die der ihm zugeführten Steuerspannung bei zu niedrigem und zu hohem Verbraucherstrom entspricht. Zum Checken des unteren Schwellwertes wird durch ein kurzzeitig auf die Eingangsklemme a gegebenes Prüfkommando der Transistor T1 gesperrt; dieser Transistor schaltet den Transistor T2 hochohmig und der Verbraucher wird kurzzeitig abgeschaltet. Die Schaltzeit ist dabei vorzugsweise so zu bemessen, daß zwar der Überwacher das Ausbleiben des Verbraucherstromes registrieren kann, der Verbraucher selbst aber nach außen hin noch nicht reagiert: Bei der Ausbildung des Verbrauchers als Signallampe soll die Schaltzeit zum vorübergehenden Abschalten der Signallampe so kurz gewählt sein, daß das menschliche Auge diesem Abschaltvorgang noch nicht folgen kann. Bei einem Verbraucher mit nicht optisch erkennbaren Betriebszuständen ist durch Puffern des Verbrauchers, beispielsweise durch einen Kondensator, sicherzustellen, daß die kurzzeitige Abschaltung des Verbrauchers auf nachgeordnete Schaltkreise keinen Einfluß hat.

Soll der Prüfvorgang vorgenommen werden, wenn der Verbraucher abgeschaltet ist, dann wird durch Anlegen von Massepotential an die Anschlußklemme a zunächst ein kurzzeitiges Anschalten des Verbrauchers herbeigeführt; dabei spricht bei ordnungsgerechtem Betriebszustand der am Anschalt- und am Überwachungsvorgang beteiligten Schaltmittel die Schaltstrecke S1 an und gibt die Meldung für das Fließen eines ausreichend hohen Verbraucherstromes an den Optokoppler OK2 ab. An der Anschlußklemme b ist dabei während dieser Prüfphase negatives Potential abgreifbar.

Ist — wie im vorliegenden Ausführungsbeispiel — der zu steuernde und zu überwachende Verbraucher als Signallampe ausgebildet, dann tritt das Problem auf, daß beim Anschalten dieses Verbrauchers vorübergehend ein oberhalb des Betriebsstromes liegender Kaltstrom fließt. Dieser nur kurzzeitig fließende Strom soll aber nicht zum Durchsteuern des Schalters S2, OK2 und damit zur Ausgabe einer Störungsmeldung führen. Aus diesem Grunde ist an den Steuereingang des zweiten Schalters ein Kondensator C angeschlossen, der nur bei länger anliegender ausreichend hoher Steuerspannung ein Durchsteuern dieses Schalters S2, OK2 möglich macht.

Läßt sich der Verbraucher L während des Prüfvorganges nicht anschalten, dann wird der Schalter S1, OK2 auch nicht durchgesteuert und die entsprechende Rückmeldung (negatives Potential an der Anschlußklemme b) unterbleibt. Diese Rückmeldung unterbleibt auch, wenn zwar der Verbraucher stromdurchflossen ist, der Schalter S1, OK2 wegen eines Defektes aber nicht umsteuerbar ist, die Überwachungseinrichtung also nicht ordnungsgerecht arbeitet.

Um nun zu prüfen, ob der Überwacher bei einem zu hohen Verbraucherstrom eine Störungsmeldung ausgeben würde oder nicht, ist es selbstverständlich nicht sinnvoll, den Verbraucher mit einem Überstrom zu beschicken.

Vielmehr wird das Fließen eines derartigen Stromes während des Prüfvorganges simuliert. Hierzu wird bei angeschaltetem Verbraucher durch Aufschalten von Massepotential auf die Anschlußklemme c ein ebenfalls als Optokoppler OK3 ausgebildeter dritter Schalter kurzzeitig durchgesteuert. Das Durchsteuern des dritten Schalters führt zu einer Potentialverschiebung am Steuereingang des zweiten Schalters. Diese Potentialverschiebung ist so gewählt, daß das nunmehr bei normal hohem Verbraucherstrom am Steuereingang des Schalters S2, OK2 liegende Steuerpotential dem ihm bei einem zu hohen Verbraucherstrom vom Meßwiderstand zugeführten Potential entspricht. Bei ordnungsgerechtem Betriebszustand der Überwachungseinrichtung schließt die zweite Schaltstrecke S2 die erste Schaltstrecke S1 kurz und legt damit mittelbar positives Potential an die Anschlußklemme b.

Während der Funktionsprüfung für den oberen Schwellwert der Überwachungseinrichtung ist der Stromkreis für den Verbraucher geschlossen. Hierdurch wird erreicht, daß das zum Durchsteuern des ersten Schalters S1, OK2 erforderliche Potential während dieser Prüfphase am Steuereingang dieses Schalters anliegt. Das Abschalten der Leuchtdiode des Optokopplers OK2 während des Prüfvorganges ist damit eindeutig auf das Wirksamwerden der zweiten Schaltstrecke S2 zurückzuführen.

Würde während der Funktionsprüfung für den oberen Schwellwert der Überwachungseinrichtung der Verbraucherstromkreis aufgetrennt sein, dann müßte das Verlöschen der Leuchtdiode des Optokopplers OK2 nicht zwingend auf das Wirksamwerden der zweiten Schaltstrecke S2 zurückzuführen sein; wenn nämlich in dieser Prüfphase das Steuerpotential für die beiden Schwellwertschalter ausfällt (dies könnte z. B. auf einen Defekt am Optokoppler OK3 oder an seinen Zuleitungen zurückzuführen sein), so würde die Leuchtdiode des Optokopplers OK2 allein über die erste Schaltstrecke S1 dunkel geschaltet. Da eingangsseitig nicht erkennbar ist, ob die Leuchtdiode durch eine hochohmige erste Schaltstrecke S1 oder eine diese kurzschließende zweite Schaltstrecke S2 abgeschaltet wurde, wäre die übermittelte Zustandsmeldung nicht eindeutig, und das gesteckte Ziel, die Überprüfung des Funktionsverhaltens der Überwachungseinrichtung, wäre nicht erfüllt.

Die Anwendung der Erfindung erfordert es daher, durch geeignete Maßnahmen dafür Sorge zu tragen, daß die Funktionsprüfung des Überwachers bezüglich seines oberen Schwellwertes stets bei angeschaltetem Verbraucher erfolgt. Bei abgeschaltetem Verbraucher ist der dritte Schalter OK3 jeweils im Anschluß an das Anschalten des Verbrauchers durchzusteuern; nur so läßt sich das ordnungsgerechte Arbeiten des Überwachers bei einem zu niedrigen, bei einem normal hohen und bei einem zu hohen Verbraucherstrom feststellen. Ist der Verbraucher angeschaltet, dann ist nach seinem vorübergehenden kurzzeitigen Abschalten zu Prüfzwecken ein Wiederanschalten erforderlich und erst danach ein Durchsteuern des dritten Schalters OK3 zulässig, weil nur bei dieser Schaltfolge das Reagieren des Überwachers auf die unterschiedlichen Verbraucherströme sicher feststellbar ist.

In dem dargestellten Ausführungsbeispiel sind die Überwachungseinrichtungen für die Kennzeichnung des Betriebszustandes nur eines einzigen Verbrauchers angegeben; bei mehreren getrennt zu schaltenden Verbrauchern sind entsprechend viele Überwachungseinrichtungen zu verwenden. Diese Überwachungseinrichtungen können unabhängig voneinander betrieben werden, sie können aber auch voneinander abhängig sein. Handelt es sich bei zwei zu steuernden Verbrauchern beispielsweise um den Haupt- und den Nebenfaden einer Signallampe, von denen der Nebenfaden automatisch anzuschalten ist, wenn ein Defekt am Hauptfaden auftritt, dann kann man diese Automatik dadurch bewirken, daß man die Anschlußklemme b der dem Hauptfaden zugeordneten Überwachungseinrichtung unter Zwischenschaltung eines Inverters mit der Anschlußklemme a der dem Nebenfaden zugeordneten Überwachungseinrichtung verbindet; der Inverter kann z. B. als vom Potential der Anschlußklemme b steuerbarer Schalter ausgebildet sein.

## Patentansprüche

1. Einrichtung zum Überwachen des Betriebszustandes eines elektrischen Verbrauchers (L) unter Verwendung zweier von einem an einem Meßwiderstand (W) abgreifbaren Spannungsabfall steuerbarer Schwellwertschalter (S1, OK2; S2, OK2), von denen einer (S1, OK2) auf das Überschreiten eines vorgegebenen unteren Schwellwertes eines Steuerpotentials reagiert und der andere (S2, OK2) auf das Überschreiten eines vorgegebenen oberen Schwellwertes des Steuerpotentials reagiert und dabei den ersten Schwellwertschalter (S1, OK2) in die Schaltstellung steuert, die dieser auch bei einem unterhalb des vorgegebenen unteren Schwellwertes liegenden Steuerpotential einnimmt, dadurch gekennzeichnet, daß der Meßwiderstand (W), der das Steuerpotential für die Schwellwertschalter (S1, OK2; S2, OK2) liefert, mit dem Verbraucher (L) in Reihe liegt, daß der erste Schwellwertschalter (S1, OK2) einen Überwacher (TU0, TUN) schaltet, daß in der Einrichtung zu deren Funktionsprüfung für den Fall eines zu hohen Verbraucherstromes eine Vorrichtung (OK3) vorhanden ist, die auf den Steuereingang des auf das Überschreiten des vorgegebenen oberen Schwellwertes des Steuerpotentials reagierenden Schwellwertschalters (S2, OK2) ein Prüfpotential aufschaltet, welches das am Steuereingang dieses Schwellwertschalters (S2, OK2) anliegende, vom Meßwiderstand (W) abgegriffene Steuerpotential, das bei angeschaltetem Verbraucher (L) und ordnungsgemäßem Verbraucherstrom auftritt, bis über die Ansprechgrenze des Schwellwertschalters (S2, OK2) anhebt, und daß zur Funktionsprüfung der Einrichtung für den Fall eines zu niedrigen Verbraucherstromes eine in der Einrichtung vorgesehene Vorrichtung (OK1, T1, T2) diesen Verbraucherstrom kurzzeitig abschaltet.

2. Einrichtung nach Anspruch 1, dadurch gekennzeichnet, daß der Steuereingang des auf das Überschreiten des vorgegebenen oberen Schwellwertes des Steuerpotentials ansprechenden Schwellwertschalters (S2, OK2) an den einen Pol eines Kondensators (C) angeschlossen ist, dessen anderer Pol auf Bezugspotential liegt.

3. Einrichtung nach Anspruch 1, dadurch gekennzeichnet, daß zum Schalten des Überwachers (TUN, TU0) ein Optokoppler (OK2) vorgesehen ist, dessen Leuchtdiode im Laststromkreis des ersten Schwellwertschalters (S1, OK2) angeordnet ist, daß der aus Schaltstrecke (S1) des ersten Schwellwertschalters (S1, OK2) und Leuchtdiode des Optokopplers (OK2) gebildeten Reihenschaltung die Schaltstrecke (S2) des zweiten Schwellwertschalters (S2, OK2) parallelgeschaltet ist, der auf das Überschreiten des vorgegebenen oberen Schwellwertes des Steuerpotentials reagiert, und daß der Überwacher aus zwei Transistoren (TUN, TU0) besteht, von denen der eine (TU0) ein npn- und der andere (TUN) ein pnp-Transistor ist, deren Schaltstrecken in Reihe geschaltet an den beiden Polen (+, −) einer Spannungsquelle liegen, und daß die Steuerelektroden der Transistoren miteinander verbunden sind und über einen Widerstand an den einen Pol der Spannungsquelle sowie über die Schaltstrecke des Optokopplers (OK2) an den anderen Pol der Spannungsquelle angeschlossen sind.

## Claims

1. Apparatur for monitoring the operating state of an electrical load (L) employing two threshold value switches (S1, OK2; S2, OK2) which are controllable by a voltage drop which can be tapped at a measuring resistor (W), one (S1, OK2) of which threshold value switches reacts to overshooting of a predetermined lower threshold value of a control potential and the other (S2, OK2) reacts to overshooting of a predetermined upper threshold value of the control potential and thereby controls the first threshold value switch (S1, OK2) into that switching position which the latter assumes in the case of a control potential below the predetermined lower threshold value, characterised in that the measuring resistor (W) which supplies the control potential for the threshold value switches S1, OK2; S2, OK2) is connected in series with the load (L), that the first threshold value switch (S1, OK2) switches a monitor (TU0, TUN), that for function testing in the event of a load current which is too high, there is arranged in the apparatus a device (OK3) which switches a test potential to the control input of the threshold value switch (S2, OK2) which reacts to overshooting of the predetermined upper threshold value of the control potential, which test potential raises the control potential connected to the control input of the threshold value switch (S2, OK2) from the measuring resistor (W) occurring in the case of a connected load (L) and regular load current to a level above the response limit of the threshold value switch (S2, OK2), and that for the function test of the apparatus in the event of a load current which is too low, a device (OK1, T1, T2) arranged in the apparatus temporarily switches off this load current.

2. Apparatus as claimed in Claim 1, characterised in that the control input of the threshold value switch (S2, OK2) which responds to overshooting of the predetermined upper threshold value of the control potential is connected to one pole of a capacitor (C) whose other pole is connected to reference potential.

3. Apparatus as claimed in Claim 1, characterised in that in order to switch the monitor (TUN, TU0), there is provided an opto-coupler (OK2) having its luminous diode arranged in the load circuit of the first threshold value switch (S1, OK2), that the series connection formed by the switching path (S1) of the first threshold value switch (S1, OK2) and the luminous diode of the opto-coupler (OK2) is connected in parallel to the switching path (S2) of the second threshold value switch (S2, OK2), which reacts to overshooting of the predetermined upper threshold value of the control potential, and that the monitor consists of two transistors (TUN, TU0), of which one (TU0) is an npn-transistor and the other (TUN) is a pnp-transistor, whose switching paths are connected in series at the two poles (+, −) of a voltage source, and that the control electrodes of the transistors are connected to one another and linked to one pole of the voltage source via a resistor and to the other pole of the voltage source via the switching path of the opto-coupler (OK2).

**Revendications**

1. Dispositif pour contrôler l'état de fonctionnement d'un appareil (L) consommateur d'électricité, avec mise en œuvre de deux commutateurs à valeur de seuil (S1, OK2; S2, OK2) susceptibles d'être commandés par une chute de tension pouvant être prélevée au niveau d'une résistance de mesure (W), dont l'un (S1, AK2) réagit au dépassement de la valeur de seuil inférieure prédéterminée d'un potentiel de commande et l'autre (S2, OK2) au dépassement d'une valeur de seuil supérieure prédéterminée du potentiel de commande, en commandant le premier commutateur de valeur de seuil (S1, OK2) dans la position de commutation que celui-ci assume également pour un potentiel de commande se situant en-dessous de la valeur de seuil inférieure prédéterminée, caractérisé par le fait
— que la résistance de mesure (W) qui fournit le potentiel de commande pour les commutateurs à valeur de seuil (S1, OK2; S2, OK2) est montée en série avec l'appareil (L) consommateur d'électricité,
— que le premier commutateur de valeur de seuil (S1, AK2) commute un contrôleur (TU0, TUN),
— qu'il est prévu dans le dispositif, en vue du contrôle de son fonctionnement, dans le cas d'un courant de consommation trop élevé, un agencement (OK3) qui applique à l'entrée de commande du commutateur à valeur de seuil (S2, OK2) qui réagit au dépassement de la valeur de seuil supérieure prédéterminée du potentiel de commande, un potentiel de contrôle qui amène le potentiel de commande prélevé par la résistance de mesure (W) et appliqué à l'entrée de ce commutateur à valeur de seuil (S2, OK2), et qui apparaît lorsque l'appareil (L) consommateur d'électricité est branché et que le courant consommé est correct, jusqu'au-dessus de la limite de réponse du commutateur à valeur de seuil (S2, OK2), et
— que pour le contrôle du fonctionnement du dispositif, pour le cas d'un courant de consommation trop bas, un agencement (OK1, T1, T2) prévu dans le dispositif interrompt pour une courte durée ce courant de consommation.

2. Dispositif selon la revendication 1, caractérisé par le fait que l'entrée de commande du commutateur à valeur de seuil (S2, OK2), qui répond au dépassement de la valeur de seuil supérieure prédéterminée du potentiel de commande, est reliée à un pôle d'un condensateur (C) dont l'autre pôle est au potentiel de référence.

3. Dispositif selon la revendication 1, caractérisé par le fait,
— que pour commuter le contrôleur (TUN, TU0), il est prévu un optocoupleur (OK2) dont la diode luminescente est disposée dans le circuit de courant de charge du premier commutateur à valeur de seuil (S1, OK2),
— qu'en parallèle sur le montage série, qui est constitué par la voie de commutation (S1) du premier commutateur à valeur de seuil (S1, OK2) et par la diode luminescente de l'optocoupleur (OK2), est montée la voie de commutation (S2) du second commutateur à valeur de seuil (S2, OK2) qui réagit au dépassement de la valeur de seuil supérieure prédéterminée du potentiel de commande, et

— que le contrôleur est constitué par deux transistors (TUN, TU0) dont l'un (TU0) est un transistor npn et l'autre (TUN) est un transistor pnp, dont les voies de commutation sont montées en série et sont reliées aux deux pôles (+, —) d'une source de tension, et que les électrodes de commande des transistors sont reliées entre elles et sont reliées par l'intermédiaire d'une résistance à l'un des pôles de la source de tension, de même que, par l'intermédiaire de la voie de commutation de l'optocoupleur (OK2), à l'autre pôle de la source de tension.